# EUROPEAN PATENT SPECIFICATION

(11) **EP 2 648 493 B1**
(45) Date of publication and mention of the grant of the patent: **30.11.2016**
(21) Application number: 12397512.0
(22) Date of filing: 02.04.2012
(51) Int. Cl.: H05K 5/02

(54) **Electric apparatus**
Elektrische Vorrichtung
Appareil électrique

(43) Date of publication of application: 09.10.2013
(73) Proprietor: ABB Technology Oy, 00380 Helsinki (FI)
(72) Inventor: Millner, Dan, 00380 Helsinki (FI); Tuomola, Juha, 00380 Helsinki (FI); Hamari, Juha, 00380 Helsinki (FI)
(74) Representative: Kolster Oy Ab

(56) References cited:
- EP-A1- 1 603 379
- DE-A1- 3 626 726
- US-A- 5 934 368
- US-A- 6 161 765

## Description

### BACKGROUND OF THE INVENTION

### FIELD OF THE INVENTION

This invention relates to an electric apparatus, and more specifically, to a solution for avoiding damages caused to an electric apparatus by water.

### DESCRIPTION OF PRIOR ART

Previously there is known an electric apparatus with an electric device arranged in a housing enclosing the electric apparatus from the surrounding environment. Even though the housing efficiently encloses the electric apparatus by preventing water and air from entering the apparatus from the outside, water in the housing may still be a problem. During use of this known apparatus, heat generated by the electric device is sufficient to prevent damages due to water. However, once the use of the electric apparatus ends and the temperature in the housing drops, moisture in the air inside the housing may under certain conditions condensate into water.

In the previously known apparatus an electric resistor is used for heating the inside of the housing when necessary. Typically such situations occur when the use of the electric device has ended. Due to this heating, damages caused by water can be avoided. However, a drawback with this prior art solution is the amount of energy needed for the electric resistor. This energy is more or less wasted, which is not acceptable due to the costs for obtaining the energy and due to environmental reasons.

Previously there is also known from US - 5 934 368 A, EP - 1603 379 A1 and DE - 36 26 726 A1 solutions where material absorbing moist is arranged in connection with an opening in a housing to ensure that moist can be removed from within the housing by an airstream. However, a drawback with such a solution is the need to provide the housing with openings allowing an airstream to pass through the walls of the housing. Such an opening will eventually allow dirt to enter the housing, or it will require a filter that needs regular maintenance to remove dirt from the filter.

Previously there is also known from US - 6 161 765 A an outdoor enclosure with a sorption device adsorbing water vapour. In order to allow the sorption device to release collected water the, sorption device is provided with a heater with heats the sorption device sufficiently to release water, which naturally requires additional energy for the heater.

### SUMMARY OF THE INVENTION

An object of an embodiment of the present invention is to solve the above-mentioned drawback and to provide an electric apparatus in which problems caused by water can be avoided simultaneously with minimizing waste of energy. This object is achieved with the electric apparatus according to claim 1.

The use of a receptacle containing desiccant makes it possible to collect moist from within the housing of the electric apparatus such that the risk of damages due to water can be minimized also when the electric device is out of use. A thermal connection between the receptacle and the electric device is utilized for removing moisture from the desiccant while the electric apparatus is in use. Therefore, excess heat produced by the electric device can be used for preparing the desiccant for a new period during which the desiccant collects moist.

Preferred embodiments of the invention are disclosed in the dependent claims.

### BRIEF DESCRIPTION OF DRAWINGS

In the following the present invention will be described in closer detail by way of example and with reference to the attached drawings, in which
Figure 1 is a block diagram of an electric apparatus,
Figure 2 illustrates a receptacle of the apparatus in Figure 1, and
Figure 3 is an exploded view of the receptacle in Figure 2.

### DESCRIPTION OF AT LEAST ONE EMBODIMENT

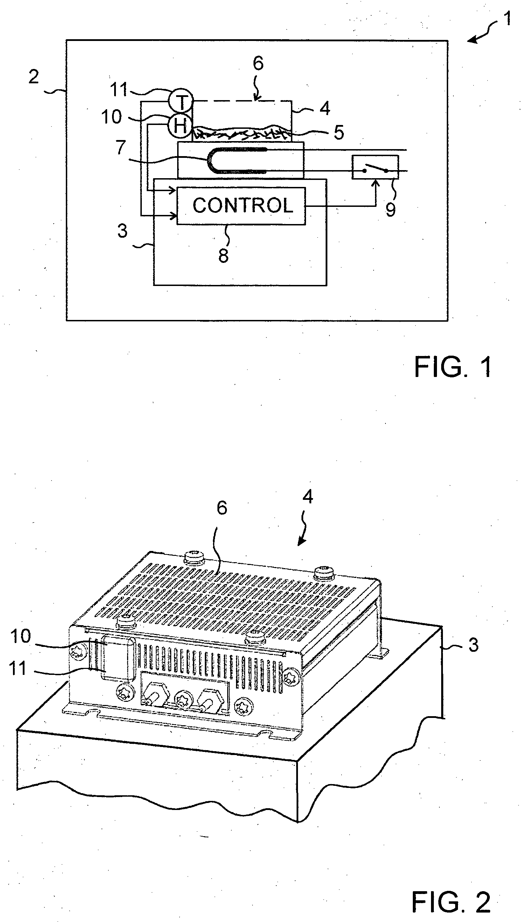

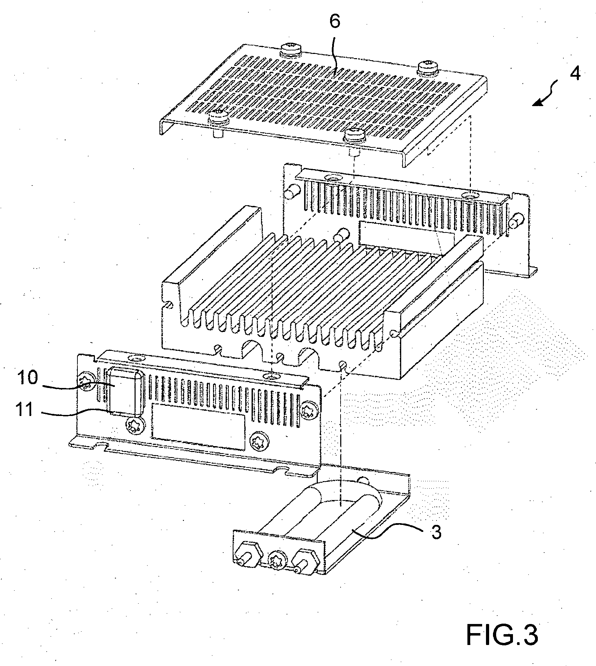

Figures 1 to 3 illustrate an electric apparatus 1. In the following explanations it is, by way of example, assumed that the electric device is a periodically operating electric device, in other words an electric device which, is not continuously in use but is instead commonly out of use for relatively long periods of time. An example of such a periodically operating electric device is a PV inverter (Photovoltaic Inverter), in other words an inverter converting the variable DC output of a solar panel into an AC output. Such a PV inverter is for practical reasons out of use at night when sunlight is not available. However, it should be observed that the invention may be implemented also for other electric apparatuses.

The electric apparatus 1 includes a housing 2 which encloses an electric device 3 from the surrounding environment. In the case of a housing for outdoor installation, the housing has been manufactured to efficiently prevent dirt and water from entering the housing 2 In most implementations the housing can be practically air-tight without a need for any ventilation arrangement to the surrounding environment.

During use, the electric device 3 generates heat. The generated excess heat from the electric device 3 is sufficient to raise the temperature inside the housing 2 sufficiently to avoid problems due to water. However, when the electric device 3 is not in use, the temperature inside the housing 2 falls and moisture in the air inside the housing 2 may under certain conditions condensate into water.

In the illustrated embodiment, the electric apparatus 1 is provided with a receptacle 4 for containing a desiccant 5. In this connection the term "desiccant" refers to a material capable of obtaining water from the gas (usually air) surrounding it such that the surrounding gas can be kept dry and almost free of moisture. The receptacle 4 has an opening 6, or actually several openings in the illustrated example, which allows gas to flow between the interior of the receptacle 4 and the interior of the housing 2. In this way the desiccant 5 comes into contact with moisture in the housing 2, and the air inside the housing 2 can be kept sufficiently dry, also during periods when the electric device 3 is not in use.

One suitable desiccant 5 for use in the illustrated example is silica gel, which is an amorphous silicon dioxide usually available as small crystals. Silica gel has an excellent capability of absorbing moisture directly from air. Additionally, once the silica gel has absorbed as much water as it possibly can, it can be regenerated such that the water or moisture is removed from the silica gel. Such regeneration is achieved by heating the silica gel to a sufficiently high temperature, usually to a temperature higher than 100°C, and by keeping the temperature at this level for a sufficient time period (usually a few hours). After such regeneration, the silica gel is again ready for absorbing water.

In the illustrated embodiment, the receptacle 4 is thermally connected to the electric device 3 for transferring heat from the electric device 2 to the desiccant 5 when the electric device 3 is in use. A thermal connection may be obtained, as in the illustrated example, by attaching the receptacle 4 to the electric device 2 such that heat may be conducted from the electric device to the receptacle 4. In that case the receptacle 4 is preferably attached or brought in direct contact with such a component of the electric device 3, which during use reaches a relatively high temperature. Such a component may be a cooling element of an IGBT module (Insulated Gate Bipolar Transistor) or an LCL filter, for instance. Alternatively, the receptacle may be thermally connected to the electric device via a gas flow (such as air flow) transferring heat dissipated by the electric device to the receptacle. In that case the receptacle may be arranged into an air flow which exits a cooling element of the electric device, for instance. Due to the thermal connection, excess heat generated by the electric device during use of the electric device may be utilized for removing moisture from the desiccant 5 in the receptacle 4.

In the illustrated embodiment the electric apparatus 1 comprises an electric resistor 7 which is thermally connected to the receptacle 4 for heating the desiccant 5 such that moisture is removed from the desiccant 5. A controller 8, which may be implemented with electrical circuits only or as a combination of a computer program and electrical circuits, controls the electric resistor 7. In the illustrated example the controller 8 controls the electric resistor 7 via a switch 9 such that the electric supply to the electric resistor can be switched on and off depending on whether or not the electric resistor 7 needs to heat the receptacle 4 at that particular moment.

In addition to the controller 8, the electric apparatus 1 may in some embodiments be optionally provided with a sensor 10 for measuring the humidity in the housing 2 and/or with a sensor 11 for measuring the temperature in the housing 2. In the illustrated example both the sensor 10 for measuring the humidity and the sensor 11 for measuring the temperature provides the controller 8 with information about the temperature and humidity (amount of water in the air) in the housing.

In many implementations, the electric device 3 alone generates, during use, enough heat to raise the temperature inside the housing 2 sufficiently for removing moist from the desiccant 5. However, if the controller 8 via the temperature sensor 11 detects that the temperature indicated by the sensor 11 is below a predetermined limit while the electric device is in use, the controller 8 controls the electric resistor 7 via the switch 9 to heat the receptacle 4 for a predetermined time period, for instance. In this way moisture can be removed from the desiccant 5, and it can be ensured that the desiccant 5 is able to keep the interior of the housing 2 dry once the use of the electric device 3 ends.

The controller 8 also monitors the humidity inside the housing 2 by means of the sensor 10. In case the air humidity indicated by the sensor 10 is above a predetermined limit, the controller 8 controls the electric resistor 7 via the switch 9 to heat the receptacle 4 for a predetermined time period, for instance. In this way the temperature inside the housing 2 can be sufficiently raised to ensure that water will not cause any problems, and additionally, moisture can be removed from the desiccant 5. Typically situations where the air humidity is above a predetermined limit may occur while the electric device 3 is out of use for a relatively long period of time, during which the amount of water absorbed by the desiccant 5 will reach the maximum level that the desiccant can absorb.

## Claims

1. An electric apparatus (1), comprising:
an electric converting device (3) such as an inverter which, during use, generates heat,
a housing (2) enclosing the electric converting device (3) from the surrounding environment by efficiently preventing dirt, water and air from entering the housing, wherein
the electric apparatus (1) comprises a receptacle (4) for containing a desiccant (5) in said housing, the receptacle (4) has an opening (6) allowing gas to flow between the interior of the receptacle (4) and the interior of the housing (2) in order for the desiccant (5) to come into contact with moisture in the housing (2), and **characterized in that**
the receptacle (4) is thermally connected to the electric converting device (3) for transferring heat from the electric converting device (3) to the desiccant (5) for removing moisture from the desiccant (5).

2. The electric apparatus according to claim 1, **characterized in that** the receptacle (4) is thermally connected to the electric converting device (3) via a cooling element of the electric converting device (3), to which the receptacle (4) is attached for conducting heat to the desiccant (5).

3. The electric apparatus according to claim 1 or 2, **characterized in that** the receptacle (4) is thermally connected to the electric converting device (3) via a gas flow transferring heat dissipated by the electric converting device (3) to the receptacle (4).

4. The electric apparatus according to one of claims 1 to 3, **characterized in that** the apparatus comprises
an electric resistor (7) thermally connected to the receptacle (4) for heating the desiccant (5) such that moisture is removed from the desiccant (5), and
a controller (8) for controlling the electric resistor (7) to heat the desiccant (5).

5. The electric apparatus according to one of claims 1 to 3, **characterized in that** the apparatus comprises
a sensor (11) for measuring the temperature in the housing (2),
an electric resistor (7) thermally connected to the receptacle (4) for heating the desiccant (5) such that moisture is removed from the desiccant (5), and
a controller (8) arranged to activate the electric resistor (7) to heat the desiccant (5) when the temperature indicated by the sensor (11) is below a predetermined limit while the electric converting device (3) is in use.

6. The electric apparatus according to one of claims 1 to 3, **characterized in that** the apparatus comprises
a sensor (10) for measuring air humidity in the housing (2),
an electric resistor (7) thermally connected to the receptacle (4) for heating the desiccant (5) such that moisture is removed from the desiccant (5), and
a controller (8) arranged to activate the electric resistor (7) to heat the desiccant (5) when the air humidity indicated by the sensor (10) is above a predetermined limit.

7. The electric apparatus according to one of claims 1 to 6, **characterized in that** the electric converting device (3) is a periodically operating electric device.

8. The electric apparatus according to one of claims 1 to 7, **characterized in that** the desiccant (5) is silica gel.

9. The electric apparatus according to one of claims 1 to 8, **characterized in that** the housing (2) is a housing for outdoor installation of an electric converting device (3).

10. The electric apparatus according to one of claims 1 to 9, **c h a r a c t e r i z e d** in that the electric apparatus (1) is an inverter converting a DC input from a solar panel to an AC output.

## Patentansprüche

1. Elektrische Vorrichtung (1), die umfasst:
eine elektrische Umwandlungseinrichtung (3), wie beispielsweise ein Wechselrichter, die in Funktion Wärme erzeugt,
ein Gehäuse (2), das die elektrische Umwandlungseinrichtung (3) gegenüber der äußeren Umgebung abschließt und damit effektiv verhindert, dass Schmutz, Wasser und Luft in das Gehäuse eindringen, wobei
die elektrische Vorrichtung (1) einen Behälter (4) umfasst, der ein Trocknungsmittel (5) in dem Gehäuse aufnimmt, wobei der Behälter (4) eine Öffnung (6) aufweist, die zulässt, dass Gas zwischen dem Innenraum des Behälters (4) und dem Innenraum des Gehäuses (2) strömt, damit das Trocknungsmittel (5) in Kontakt mit Feuchtigkeit in den Gehäuse (2) kommt, und **dadurch gekennzeichnet, dass**
der Behälter (4) thermisch mit der elektrischen Umwandlungseinrichtung (3) verbunden ist" um Wärme von der elektrischen Umwandlungseinrichtung (3) auf das Trocknungsmittel (5) zu übertragen und Feuchtigkeit aus dem Trocknungsmittel (5) zu entfernen.

2. Elektrische Vorrichtung nach Anspruch 1, **dadurch gekennzeichnet, dass** der Behälter (4) über ein Kühlelement der elektrischen Umwandlungseinrichtung (3), an dem der Behälter (4) angebracht ist, thermisch mit der elektrischen Umwandlungseinrichtung (3) verbunden ist, um Wärme zu dem Trocknungsmittel (5) zu leiten.

3. Elektrische Vorrichtung nach Anspruch 1 oder 2, **dadurch gekennzeichnet, dass** der Behälter (4) über einen Gasstrom, der von der elektrischen Umwandlungseinrichtung (3) abgeleitete Wärme zu dem Behälter (4) überträgt, thermisch mit der elektrischen Umwandlungseinrichtung (3) verbunden ist.

4. Elektrische Vorrichtung nach einem der Ansprüche 1 bis 3, **dadurch gekennzeichnet, dass** die Vorrichtung umfasst:
einen elektrischen Widerstand (7), der thermisch mit dem Behälter (4) verbunden ist, um das Trocknungsmittel (5) zu erwärmen, so dass Feuchtigkeit aus dem Trocknungsmittel (5) entfernt wird, und
eine Steuereinrichtung (8), mit der der elektrische Widerstand (7) so gesteuert wird, dass das Trocknungsmittel (5) erwärmt wird.

5. Elektrische Vorrichtung nach einem der Ansprüche 1 bis 3, **dadurch gekennzeichnet, dass** die Vorrichtung umfasst:
einen Sensor (11), mit dem die Temperatur in dem Gehäuse (2) gemessen wird,
einen elektrischen Widerstand (7), der thermisch mit dem Behälter (4) verbunden ist, um das Trocknungsmittel (5) zu erwärmen, so dass Feuchtigkeit aus dem Trocknungsmittel (5) entfernt wird, und
eine Steuereinrichtung (8), die so eingerichtet ist, dass sie den elektrischen Widerstand (7) zum Erwärmen des Trocknungsmittels (5) aktiviert, wenn die durch den Sensor (11) angezeigte Temperatur unter einer vorgegebenen Grenze liegt, während die elektrische Umwandlungseinrichtung (3) in Betrieb ist.

6. Elektrische Vorrichtung nach einem der Ansprüche 1 bis 3, **dadurch gekennzeichnet, dass** die Vorrichtung umfasst:
einen Sensor (10) zum Messen von Luftfeuchtigkeit in den Gehäuse (2),
einen elektrischen Widerstand (7), der thermisch mit dem Behälter (4) verbunden ist, um das Trocknungsmittel (5) zu erwärmen, so dass Feuchtigkeit aus dem Trocknungsmittel (5) entfernt wird, und
eine Steuereinrichtung (8), die so eingerichtet ist, dass sie den elektrischen Widerstand (7) zum Erwärmen des Trocknungsmittels (5) aktiviert, wenn die durch den Sensor (10) angezeigte Luftfeuchtigkeit unter einer vorgegebenen Grenze liegt.

7. Elektrische Vorrichtung nach einem der Ansprüche 1 bis 6, **dadurch gekennzeichnet, dass** die elektrische Umwandlungseinrichtung (3) eine periodisch arbeitende elektrische Einrichtung ist.

8. Elektrische Vorrichtung nach einem der Ansprüche 1 bis 7, **dadurch gekennzeichnet, dass** das Trocknungsmittel (5) Silikagel ist.

9. Elektrische Vorrichtung nach einem der Ansprüche 1 bis 8, **dadurch gekennzeichnet, dass** das Gehäuse (2) ein Gehäuse, für Außeninstallation einer elektrischen Umwandlungseinrichtung (3) ist.

10. Elektrische Vorrichtung nach einem der Ansprüche 1 bis 9, **dadurch gekennzeichnet, dass** die elektrische Vorrichtung (1) ein Wechselrichter ist, der einen Gleichstrom-Eingang von einem Solarpanel in einen Wechselstrom-Ausgang umwandelt.

## Revendications

1. Appareil électrique (1), comprenant :
un dispositif de conversion électrique (3) tel qu'un onduleur qui, en utilisation, génère de la chaleur,
un logement (2) enfermant le dispositif de conversion électrique (3) par rapport à l'environnement alentour en empêchant efficacement l'entrée de poussière, d'eau et d'air dans le logement, dans lequel
l'appareil électrique (1) comprend un réceptacle (4) pour contenir un siccatif (5) dans ledit logement, le réceptacle (4) comporte une ouverture (6) permettant l'écoulement de gaz entre l'intérieur du réceptacle (4) et l'intérieur du logement (2) afin que le siccatif (5) vienne en contact avec l'humidité dans le logement (2), et **caractérisé en ce que**
le réceptacle (4) est relié thermiquement au dispositif de conversion électrique (3) pour transférer la chaleur du dispositif de conversion électrique (3) au siccatif (5) pour retirer l'humidité du siccatif (5).

2. Appareil électrique selon la revendication 1, **caractérisé en ce que** le réceptacle (4) est relié thermiquement au dispositif de conversion électrique (3) par l'intermédiaire d'un élément de refroidissement du dispositif de conversion électrique (3), auquel le réceptacle (4) est attaché pour conduire la chaleur vers le siccatif (5).

3. Appareil électrique selon la revendication 1 ou 2, **caractérisé en ce que** le réceptacle (4) est relié thermiquement au dispositif de conversion électrique (3) par l'intermédiaire d'un écoulement de gaz transférant la chaleur dissipée par le dispositif de conversion électrique (3) au réceptacle (4).

4. Appareil électrique selon l'une des revendications 1 à 3, **caractérisé en ce que** l'appareil comprend :
une résistance électrique (7) reliée thermiquement au réceptacle (4) pour chauffer le siccatif (5) de sorte que l'humidité soit retirée du siccatif (5), et
un contrôleur (8) pour commander la résistance électrique (7) pour chauffer le siccatif (5).

5. Appareil électrique selon l'une des revendications 1 à 3, **caractérisé en ce que** l'appareil comprend :
un capteur (11) pour mesurer la température dans le logement (2),
une résistance électrique (7) reliée thermiquement au réceptacle (4) pour chauffer le siccatif (5) de sorte que l'humidité soit retirée du siccatif (5), et
un contrôleur (8) agencé pour activer la résistance électrique (7) pour chauffer le siccatif (5) lorsque la température indiquée par le capteur (11) est inférieure à une limite prédéterminée alors que le dispositif de conversion électrique (3) est en cours d'utilisation.

6. Appareil électrique selon l'une des revendications 1 à 3, **caractérisé en ce que** l'appareil comprend :
un capteur (10) pour mesurer l'humidité de l'air dans le logement (2),
une résistance électrique (7) reliée thermiquement au réceptacle (4) pour chauffer le siccatif (5) de sorte que l'humidité soit retirée du siccatif (5), et
un contrôleur (8) agencé pour activer la résistance électrique (7) pour chauffer le siccatif (5) lorsque l'humidité de l'air indiquée par le capteur (10) est supérieure à une limite prédéterminée.

7. Appareil électrique selon l'une des revendications 1 à 6, **caractérisé en ce que** le dispositif de conversion électrique (3) est un dispositif électrique fonctionnant périodiquement.

8. Appareil électrique selon l'une des revendications 1 à 7, **caractérisé en ce que** le siccatif (5) est un gel de silice.

9. Appareil électrique selon l'une des revendications 1 à 8, **caractérisé en ce que** le logement (2) est un logement pour l'installation à l'extérieur d'un dispositif de conversion électrique (3).

10. Appareil électrique selon l'une des revendications 1 à 9, **caractérisé en ce que** l'appareil électrique (1) est un onduleur convertissant une entrée continue provenant d'un panneau solaire en une sortie alternative.
